(19) Europäisches Patentamt
European Patent Office
Office européen des brevets

(11) **EP 4 007 090 A1**

(12) **EUROPEAN PATENT APPLICATION**
published in accordance with Art. 153(4) EPC

(43) Date of publication:
**01.06.2022 Bulletin 2022/22**

(21) Application number: **20847180.5**

(22) Date of filing: **08.06.2020**

(51) International Patent Classification (IPC):
**H01S 5/022** (2021.01)

(52) Cooperative Patent Classification (CPC):
**H01S 5/022**

(86) International application number:
**PCT/JP2020/022471**

(87) International publication number:
**WO 2021/019913 (04.02.2021 Gazette 2021/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.07.2019 JP 2019139298**

(71) Applicant: **Sony Semiconductor Solutions Corporation**
**Atsugi-shi Kanagawa 243-0014 (JP)**

(72) Inventor: **YASUKAWA, Hirohisa**
**Atsugi-shi, Kanagawa 243-0014 (JP)**

(74) Representative: **MFG Patentanwälte**
**Meyer-Wildhagen Meggle-Freund**
**Gerhard PartG mbB**
**Amalienstraße 62**
**80799 München (DE)**

(54) **SEMICONDUCTOR LASER DRIVE DEVICE, ELECTRONIC APPARATUS, AND METHOD FOR MANUFACTURING SEMICONDUCTOR LASER DRIVE DEVICE**

(57) An object of the present technique is to reduce a wiring inductance between a semiconductor laser and a laser driver in a semiconductor laser driving apparatus.

A semiconductor laser driving apparatus includes a substrate, a laser driver, and a semiconductor laser. The substrate incorporates the laser driver. The semiconductor laser is mounted on one surface of the substrate of the semiconductor laser driving apparatus. Connection wiring electrically connects the laser driver and the semiconductor laser to each other with a wiring inductance of 0.5 nanohenries or less. A sealing portion seals a connection terminal portion of the semiconductor laser for the substrate.

FIG.2

DIFFUSION PLATE 700
MUF 610
200 LASER DRIVER
100 SUBSTRATE
101 CONNECTION VIA
301 SOLDER BUMP
300 SEMICONDUCTOR LASER

EP 4 007 090 A1

**Description**

[Technical Field]

The present technique relates to a semiconductor laser driving apparatus. Specifically, the present technique relates to a semiconductor laser driving apparatus and electronic equipment including a substrate incorporating a laser driver and a semiconductor laser and a manufacturing method of the semiconductor laser driving apparatus.

[Background Art]

In an electronic apparatus having a distance measurement function, a distance measurement system called ToF (Time of Flight) has often been used from the past. ToF is a system in which a light emitting unit irradiates an object with irradiation light of a sine wave or a rectangular wave, a light receiving unit receives the reflected light from the object, and a distance measurement computing unit measures a distance on the basis of a phase difference between the irradiation light and the reflected light. In order to realize such a distance measurement function, there is known an optical module in which a light emitting element and an electronic semiconductor chip for driving the light emitting element are housed in a case and integrated. For example, an optical module that includes a laser diode array mounted in alignment on an electrode pattern of a substrate and a driver IC electrically connected to the laser diode array has been proposed (refer to, for example, PTL 1).

[Citation List]

[Patent Literature]

[PTL 1] Japanese Patent Laid-open No. 2009-170675

[Summary]

[Technical Problem]

In the related art described above, the laser diode array and the driver IC are integrated and configured as an optical module. However, in the related art, the laser diode array and the driver IC are electrically connected to each other by a plurality of wires, the wiring inductance therebetween becomes large, and there is a risk that the drive waveform of the semiconductor laser is distorted. This is particularly problematic for ToF driven at hundreds of megahertz.

The present technique has been developed in view of such a situation, and an object thereof is to reduce a wiring inductance between a semiconductor laser and a laser driver in a semiconductor laser driving apparatus.

[Solution to Problem]

The present technique has been made in order to solve the above-described problem, and a first aspect thereof is to provide a semiconductor laser driving apparatus including a substrate incorporating a laser driver; a semiconductor laser mounted on one surface of the substrate; connection wiring that electrically connects the laser driver and the semiconductor laser to each other with a wiring inductance of 0.5 nanohenries or less; and a sealing portion that seals a connection terminal portion of the semiconductor laser for the substrate, and electronic equipment including the semiconductor laser driving apparatus. This leads to an effect of electrically connecting the laser driver and the semiconductor laser to each other with a wiring inductance of 0.5 nanohenries or less.

In addition, in the first aspect, the sealing portion may form an outer wall surrounding a region including the semiconductor laser. This leads to an effect of simultaneously forming the sealing structure of the connection terminal portion of the semiconductor laser and the outer wall.

In addition, in the first aspect, a bump may be formed at the connection terminal portion of the semiconductor laser, and the sealing portion may be a mold underfill covering a region including the bump. This leads to an effect of simultaneously forming the outer wall by the mold underfill.

In addition, in the first aspect, a bonding wire may be formed at the connection terminal portion of the semiconductor laser, and the sealing portion may be a resin mold covering a region including the bonding wire. This leads to an effect of simultaneously forming the outer wall by the resin mold covering the region including the bonding wire.

In addition, in the first aspect, a diffusion plate covering an upper part of a region surrounded by the outer wall may be further provided. This leads to an effect of attaching the diffusion plate to the outer wall formed by the sealing portion.

In addition, in the first aspect, the light emitting surface of the semiconductor laser may have a structure of not being not covered with the sealing portion. This leads to an effect of sealing the connection terminal portion of the semiconductor laser without disturbing light emitted from the semiconductor laser.

In addition, in the first aspect, the sealing portion may be a capillary underfill. This leads to an effect of sealing the connection terminal portion of the semiconductor laser separately from the outer wall.

In addition, in the first aspect, it is desirable that the connection wiring have a length of 0.5 millimeters or less. In addition, it is more preferable that the connection wiring be 0.3 millimeters or less.

In addition, in the first aspect, the connection wiring may be provided via a connection via provided in the substrate. This leads to an effect of shortening the wiring length.

In addition, in the first aspect, the semiconductor laser may be arranged in such a manner that a part thereof overlaps an upper part of the laser driver. In this case, the semiconductor laser may be arranged in such a manner that a part corresponding to 50% or less of the area thereof overlaps the upper part of the laser driver.

In addition, a second aspect of the present technique is to provide a manufacturing method of a semiconductor laser driving apparatus, including a step of forming a laser driver on an upper surface of a support plate; a step of forming a substrate incorporating the laser driver by forming connection wiring of the laser driver; a step of mounting a semiconductor laser on one surface of the substrate and forming connection wiring that electrically connects the laser driver and the semiconductor laser to each other via the connection wiring with a wiring inductance of 0.5 nanohenries or less; and a step of forming a sealing portion that seals a connection terminal portion of the semiconductor laser for the substrate. This leads to an effect of manufacturing the semiconductor laser driving apparatus in which the laser driver and the semiconductor laser are electrically connected to each other with a wiring inductance of 0.5 nanohenries or less.

[Brief Description of Drawings]

[FIG. 1]

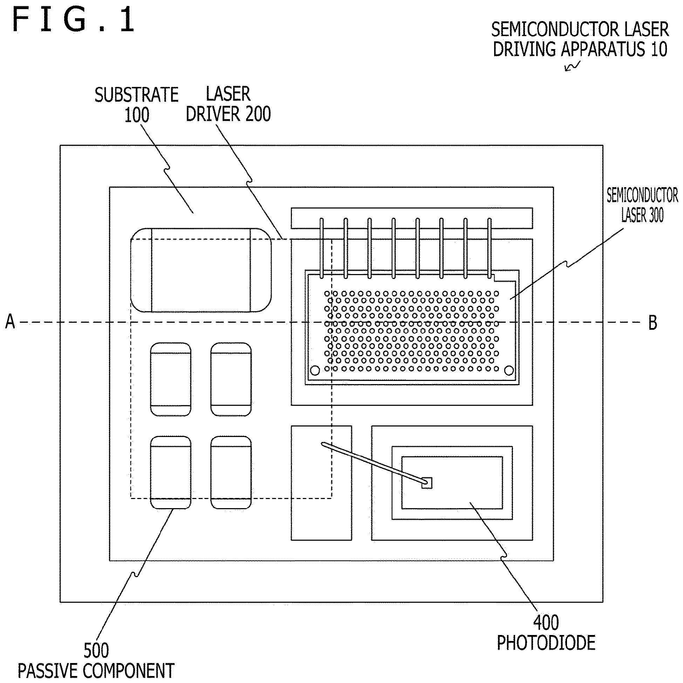

FIG. 1 is a diagram for illustrating an example of a top view of a semiconductor laser driving apparatus 10 according to an embodiment of the present technique.
[FIG. 2]

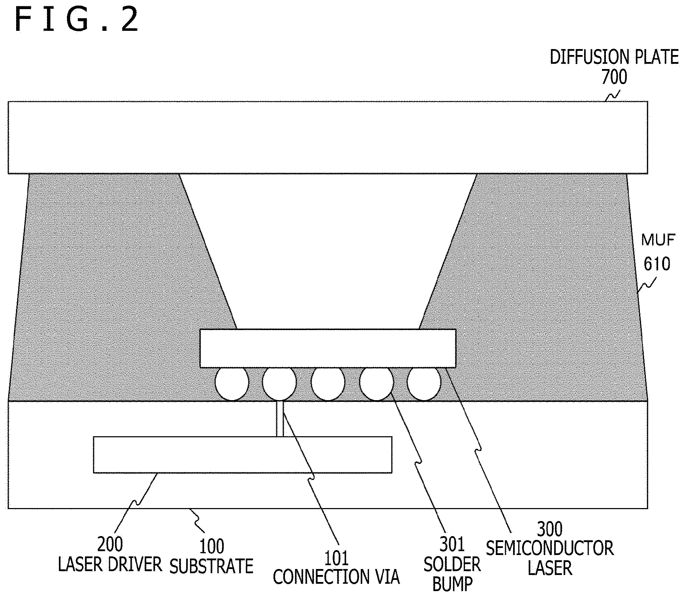

FIG. 2 is a diagram for illustrating an example of a cross-sectional view of the semiconductor laser driving apparatus 10 according to a first embodiment of the present technique.
[FIG. 3]

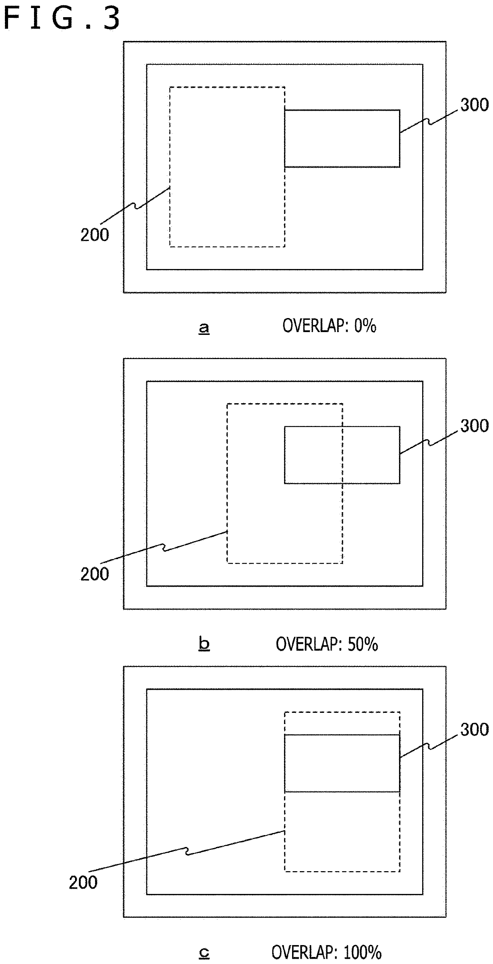

FIG. 3 depicts diagrams each illustrating the definition of an amount of overlap between a laser driver 200 and a semiconductor laser 300 according to the embodiment of the present technique.
[FIG. 4]

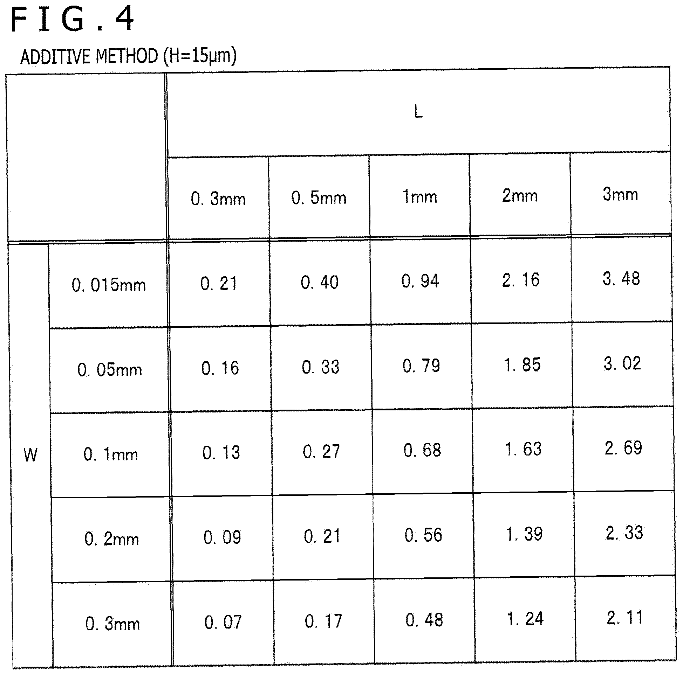

FIG. 4 is a diagram for illustrating a numerical example of a wiring inductance with respect to a wiring length L and a wiring width W in the case where a wiring pattern is formed by an additive method.
[FIG. 5]

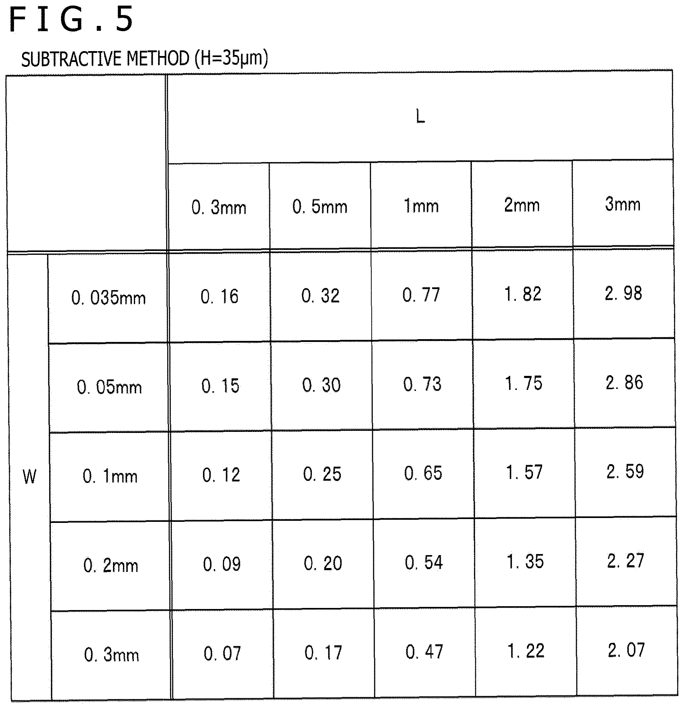

FIG. 5 is a diagram for illustrating a numerical example of the wiring inductance with respect to the wiring length L and the wiring width W in the case where a wiring pattern is formed by a subtractive method.
[FIG. 6]

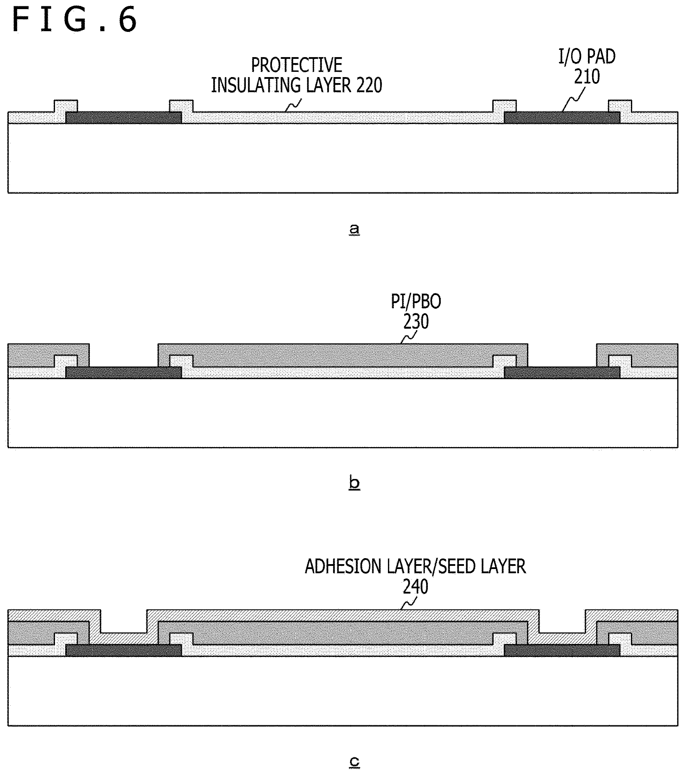

FIG. 6 depicts first diagrams each illustrating an example of a process of processing a copper land and copper redistribution layer (RDL) in a manufacturing process of the laser driver 200 according to the embodiment of the present technique.
[FIG. 7]

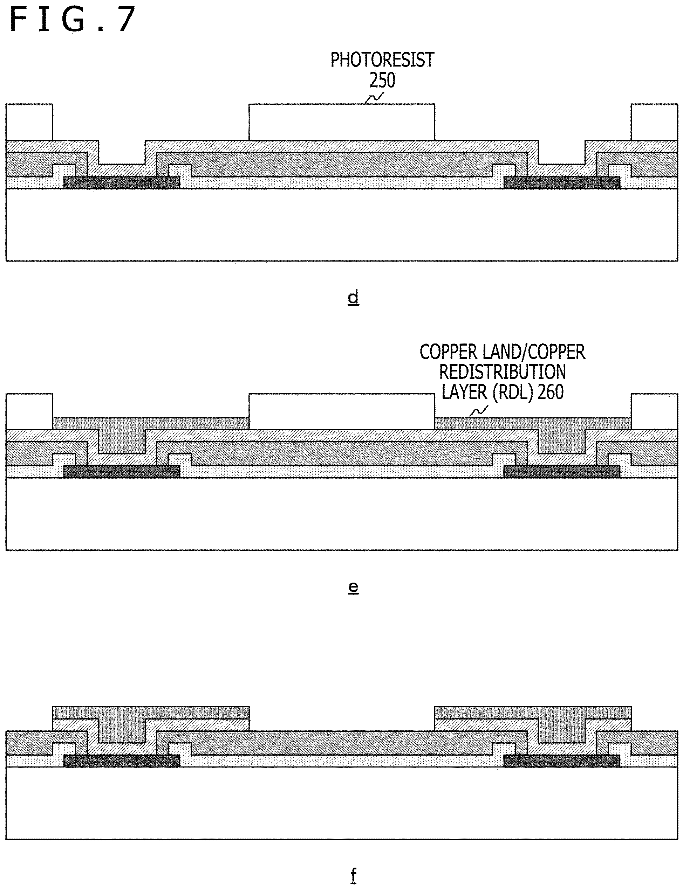

FIG. 7 depicts second diagrams each illustrating an example of a process of processing the copper land and copper redistribution layer (RDL) in the manufacturing process of the laser driver 200 according to the embodiment of the present technique.
[FIG. 8]

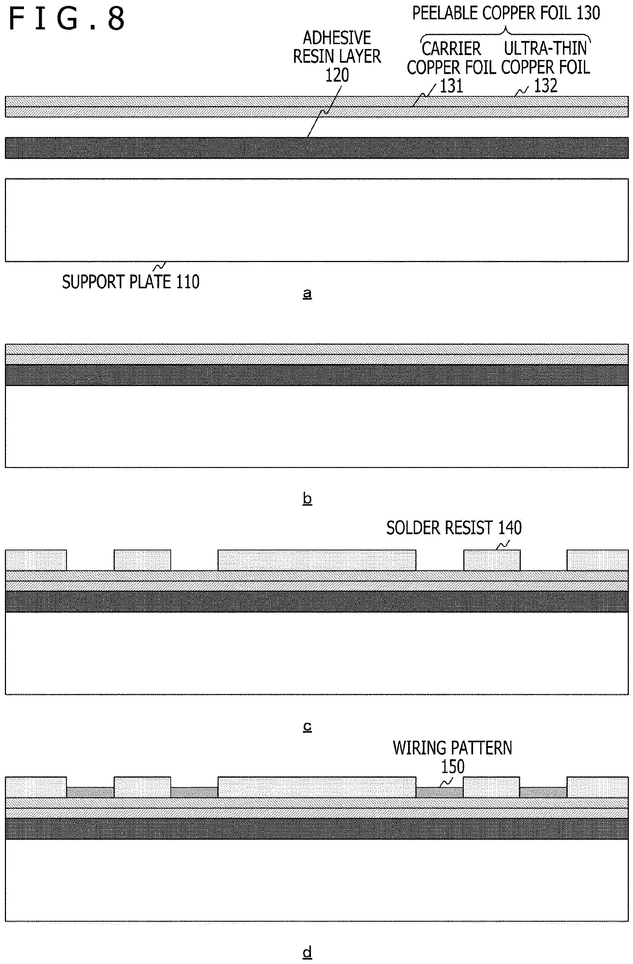

FIG. 8 depicts first diagrams each illustrating an example of a manufacturing process of a substrate 100 in the embodiment of the present technique.
[FIG. 9]

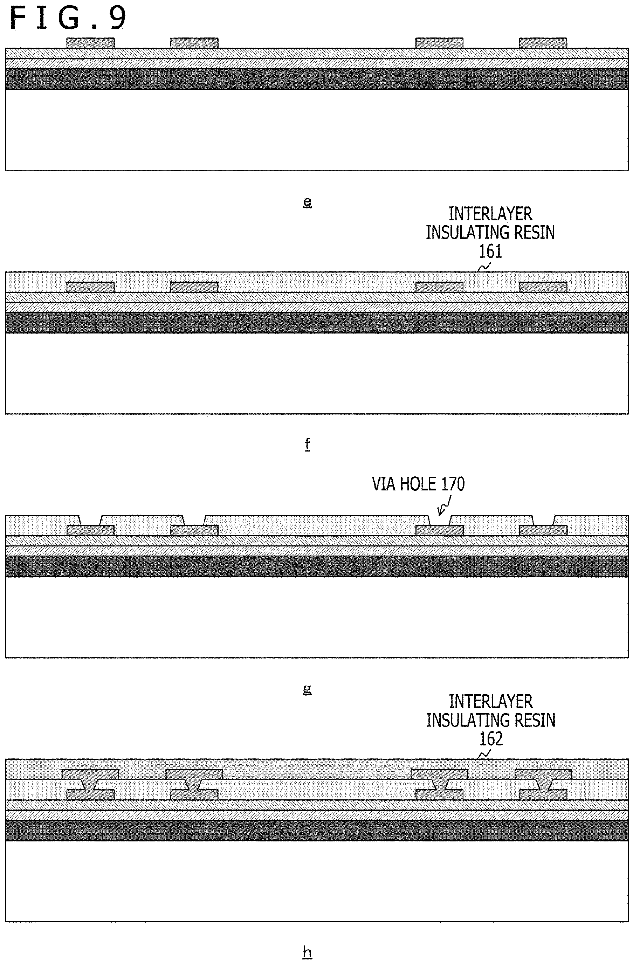

FIG. 9 depicts second diagrams each illustrating an example of the manufacturing process of the substrate 100 according to the embodiment of the present technique.
[FIG. 10]

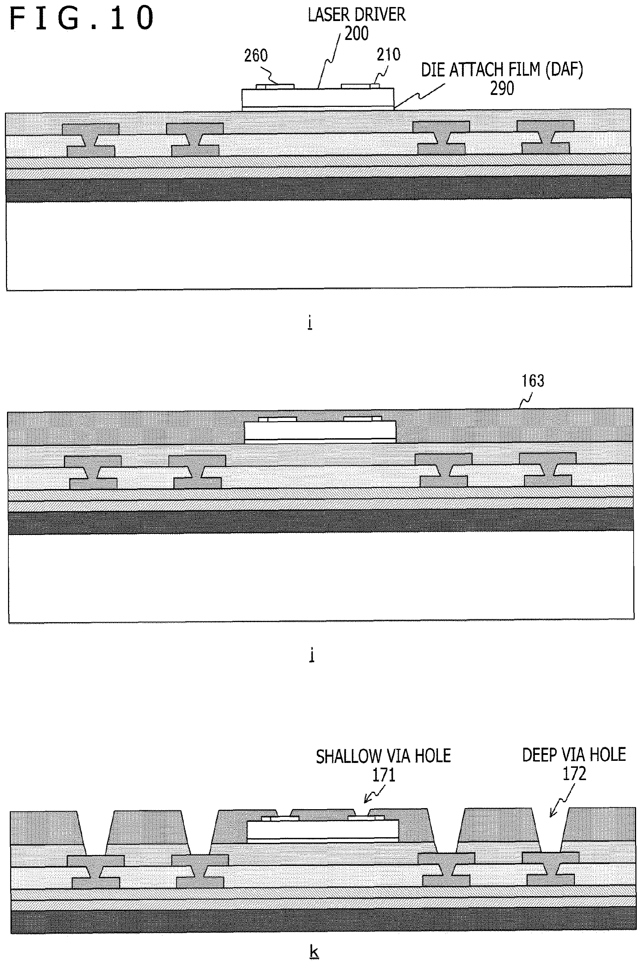

FIG. 10 depicts third diagrams each illustrating an example of the manufacturing process of the substrate 100 according to the embodiment of the present technique.
[FIG. 11]

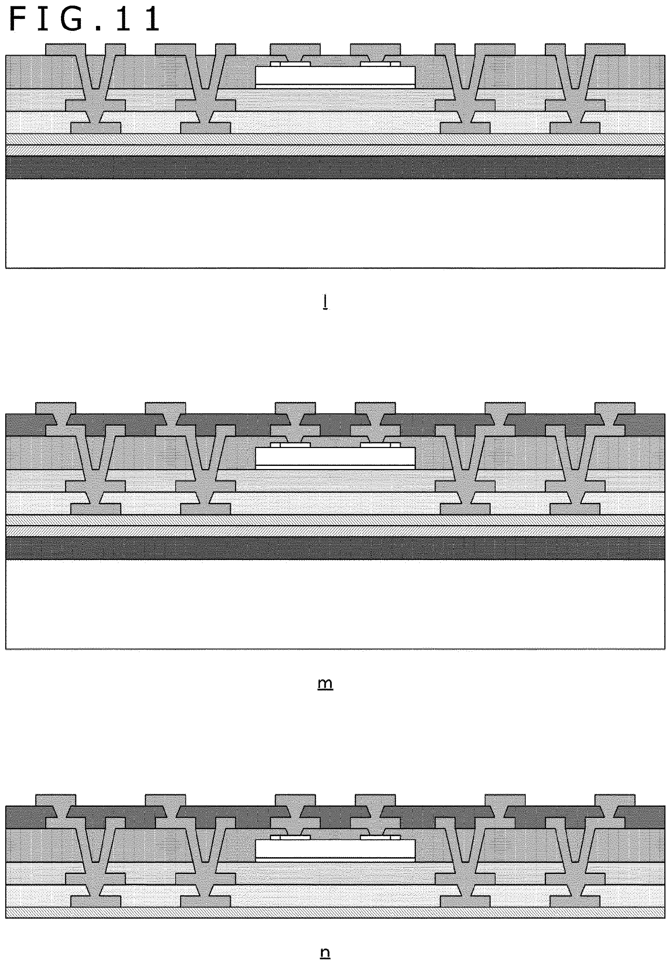

FIG. 11 depicts fourth diagrams each illustrating an example of the manufacturing process of the substrate 100 according to the embodiment of the present technique.

[FIG. 12]

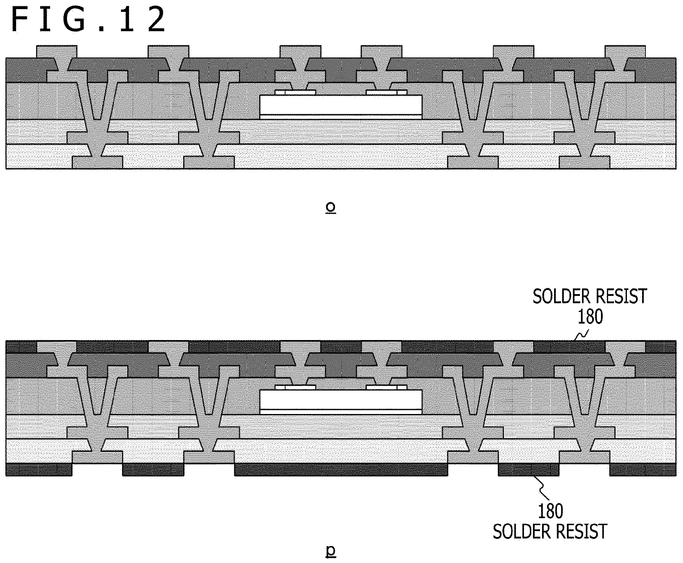

FIG. 12 depicts fifth diagrams each illustrating an example of the manufacturing process of the substrate 100 according to the embodiment of the present technique.

[FIG. 13]

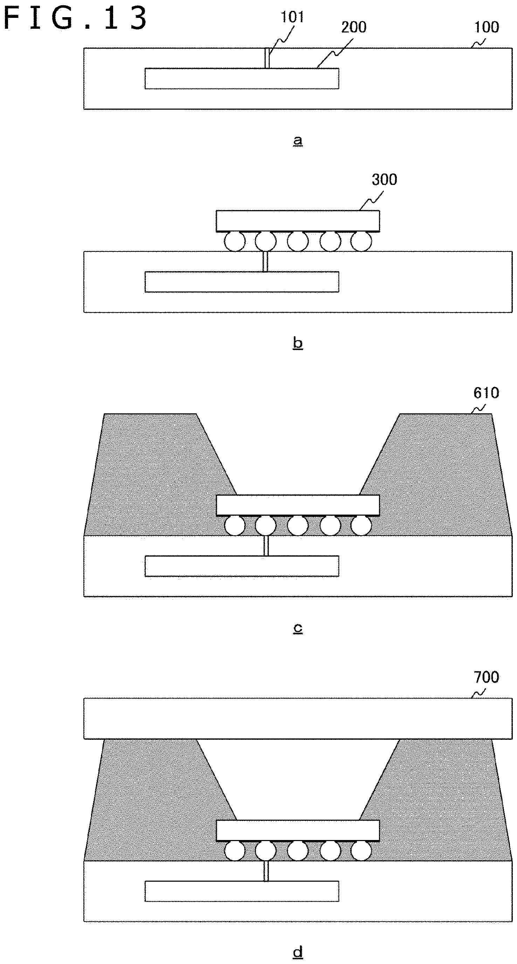

FIG. 13 depicts diagrams each illustrating an example of a manufacturing process of the semiconductor laser driving apparatus 10 according to the first embodiment of the present technique.

[FIG. 14]

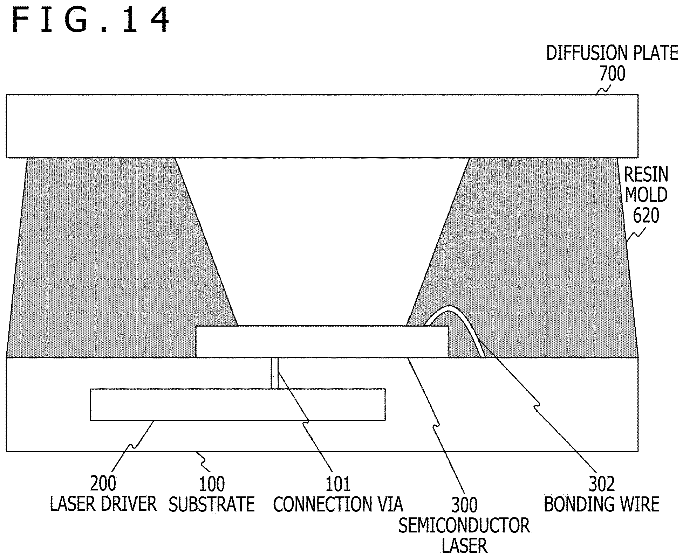

FIG. 14 is a diagram for illustrating an example of a cross-sectional view of a semiconductor laser driving apparatus 10 according to a second embodiment of the present technique.

[FIG. 15]

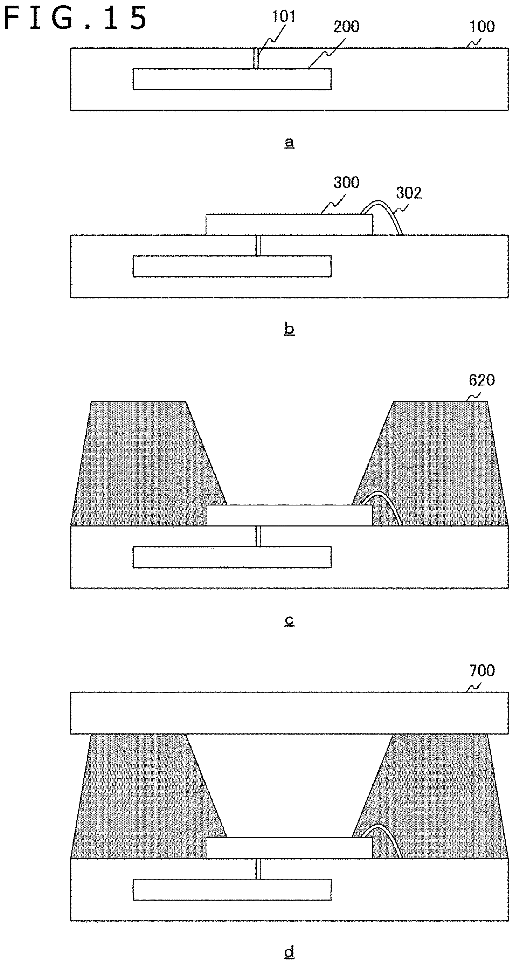

FIG. 15 depicts diagrams each illustrating an example of a manufacturing process of the semiconductor laser driving apparatus 10 according to the second embodiment of the present technique.

[FIG. 16]

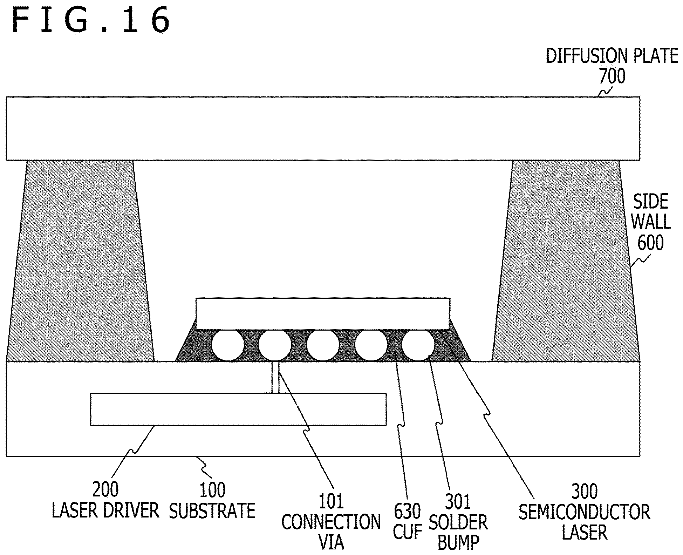

FIG. 16 is a diagram for illustrating an example of the manufacturing process of the semiconductor laser driving apparatus 10 according to the second embodiment of the present technique.

[FIG. 17]

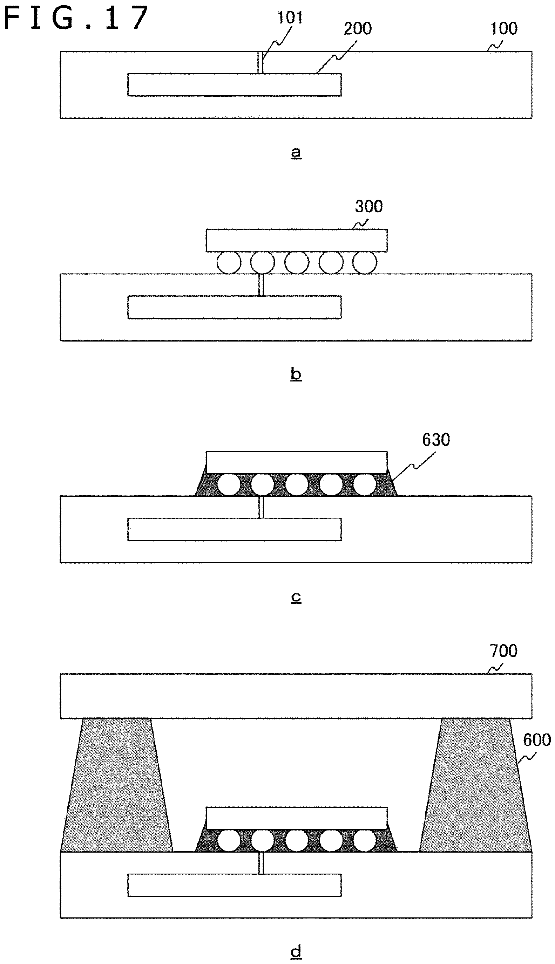

FIG. 17 depicts diagrams each illustrating an example of a manufacturing process of a semiconductor laser driving apparatus 10 according to a third embodiment of the present technique.

[FIG. 18]

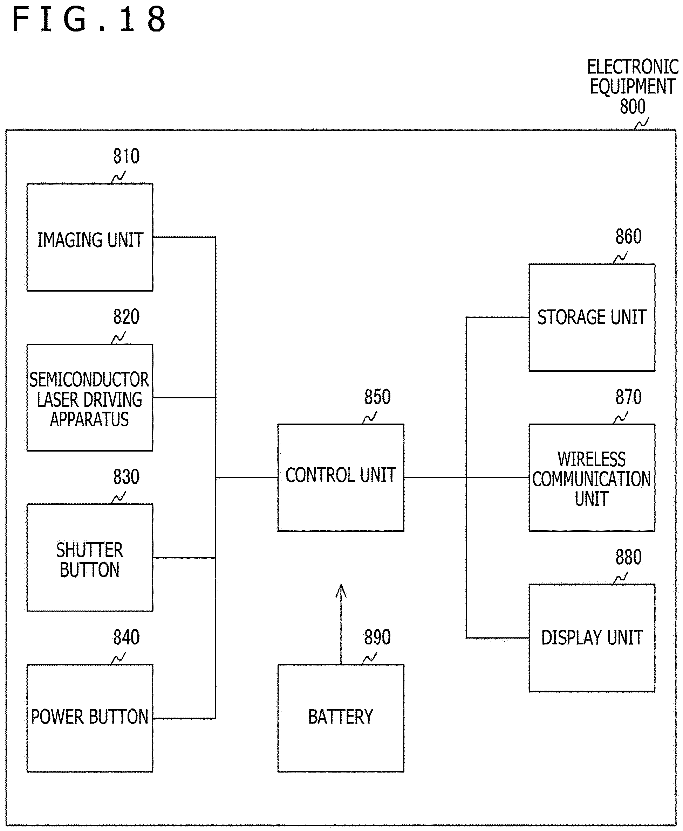

FIG. 18 is a diagram for illustrating a system configuration example of electronic equipment 800 as an application example of the embodiments of the present technique.

[FIG. 19]

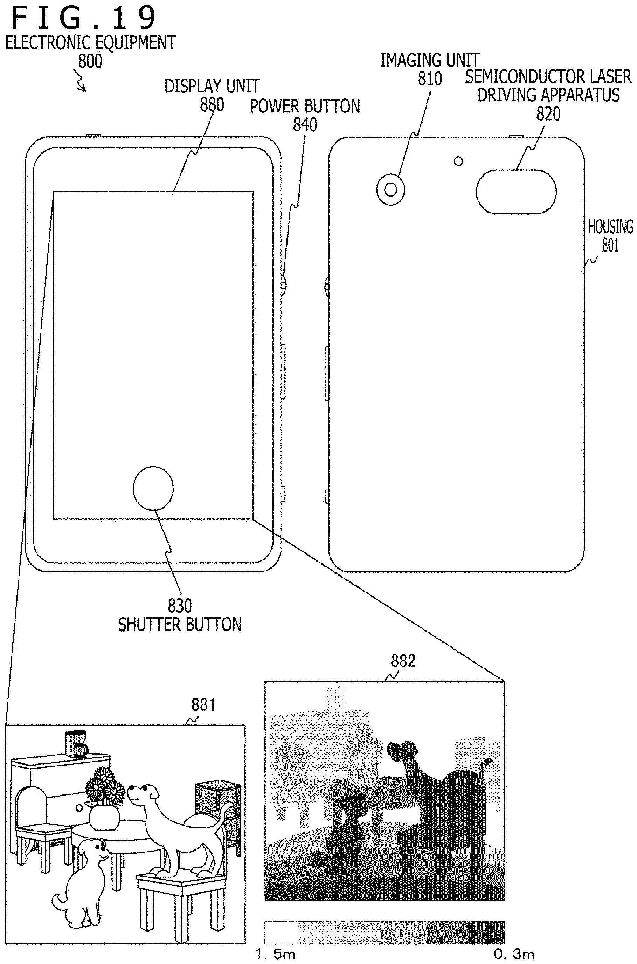

FIG. 19 is a diagram for illustrating an external configuration example of the electronic equipment 800 as an application example of the embodiments of the present technique.

[Description of Embodiments]

Hereinafter, modes for carrying out the present technique (hereinafter, referred to as embodiments) will be described. The description will be given in the following order.

1. First embodiment (example of bump protection by mold underfill)
2. Second embodiment (example of bonding wire protection by resin mold)
3. Third embodiment (example of bump protection by capillary underfill)
4. Application example

<1. First Embodiment>

[Semiconductor laser driving apparatus]

FIG. 1 is a diagram for illustrating an example of a top view of a semiconductor laser driving apparatus 10 according to an embodiment of the present technique.

The semiconductor laser driving apparatus 10 assumes measurement of a distance by ToF. ToF is high in depth accuracy although not as high as the structured light, and has such a characteristic that it can operate in a dark environment without any problem. In addition, ToF is considered to have many advantages as compared with other systems such as the structured light and the stereo camera in terms of the simplicity of the apparatus configuration and cost.

In the semiconductor laser driving apparatus 10, a semiconductor laser 300, a photodiode 400, and a passive component 500 are electrically connected by wire bonding and mounted on the surface of a substrate 100 incorporating a laser driver 200. As the substrate 100, a printed wiring board is assumed.

The semiconductor laser 300 is a semiconductor device that emits laser light by allowing a current to flow through a PN junction of a compound semiconductor. Specifically, a vertical cavity surface emitting laser (VCSEL) is assumed. However, the semiconductor laser may be either a rear-surface light-emission type or a front-surface light-emission type. Here, as the compound semiconductor to be used, for example, aluminum gallium arsenide (AlGaAs), indium gallium arsenide phosphorus (InGaAsP), aluminum gallium indium phosphorus (AlGaInP), gallium nitride (GaN), and the like are assumed.

The laser driver 200 is a driver integrated circuit (IC) for driving the semiconductor laser 300. The laser driver 200 is incorporated in the substrate 100 in a face-up state. Regarding the electrical connection between the laser driver 200 and the semiconductor laser 300, since the wiring inductance needs to be reduced, it is desirable to make the wiring length as short as possible. This specific value will be described later.

The photodiode 400 is a diode for detecting light. The photodiode 400 is used for APC (Automatic Power Control) for maintaining the output of the semiconductor laser 300 constant by monitoring the light intensity of the semiconductor laser 300.

The passive component 500 is a circuit component other than active elements such as a capacitor and a resistor. The passive component 500 includes a decoupling capacitor for driving the semiconductor laser 300.

FIG. 2 is a diagram for illustrating an example of a cross-sectional view of the semiconductor laser driving apparatus 10 according to the first embodiment of the present technique.

As described above, the substrate 100 incorporates the laser driver 200, and the semiconductor laser 300 and the like are mounted on the surface thereof. The connection between the semiconductor laser 300 and the laser driver 200 on the substrate 100 is made via a connection via 101. The wiring length can be shortened by use of the connection via 101. It should be noted that the connection via 101 is an example of the connection wiring described in the claims.

The semiconductor laser 300 is flip-chip mounted on the substrate 100. Thus, solder bumps 301 are formed at a connection terminal portion of the semiconductor laser 300. However, other materials such as a copper (Cu) pillar bump and a gold (Au) bump may be used as the connection terminal portion.

In order to ensure connection reliability, it is necessary to fill the connection terminal portion of the semiconductor laser 300 with an underfill. In the first embodiment, an MUF (Mold UnderFill) 610 is used. The MUF 610 is an example of the sealing portion described in the claims.

In addition, the semiconductor laser 300, the photodiode 400, and the passive component 500 mounted on the surface of the substrate 100 are surrounded by the MUF 610. Thus, the underfill of the connection terminal portion of the semiconductor laser 300 is formed by the MUF 610 while side wall portions are simultaneously formed. As a material of the MUF 610, for example, a thermosetting resin is assumed.

The upper surface surrounded by the MUF 610 is covered with a diffusion plate 700. The diffusion plate 700 is an optical element for diffusing the laser light from the semiconductor laser 300, and is also called a diffuser.

FIG. 3 depicts diagrams each illustrating the definition of an amount of overlap between the laser driver 200 and the semiconductor laser 300 according to the embodiment of the present technique.

As described above, since the connection between the semiconductor laser 300 and the laser driver 200 is assumed to be made via the connection via 101, the semiconductor laser 300 and the laser driver 200 are arranged while being overlapped one on another when viewed from the upper surface. On the other hand, it is desirable to provide a thermal via on the lower surface of the semiconductor laser 300, and it is also necessary to secure a region therefor. Accordingly, in order to clarify the positional relation between the laser driver 200 and the semiconductor laser 300, the amount of overlap between the two is defined as follows.

In the arrangement illustrated in a of FIG. 3, there is no overlap region between the two when viewed from the upper surface. The overlap amount in this case is defined as 0%. On the other hand, in the arrangement illustrated in c of FIG. 3, the entire semiconductor laser 300 overlaps the laser driver 200 when viewed from the upper surface. The overlap amount in this case is defined as 100%.

Then, in the arrangement illustrated in b of FIG. 3, the half region of the semiconductor laser 300 overlaps the laser driver 200 when viewed from the upper surface. The overlap amount in this case is defined as 50%.

In the embodiment, the overlap amount is desirably larger than 0% to provide a region for the above-described connection via 101. On the other hand, when considering that a certain number of thermal vias 102 are to be arranged directly under the semiconductor laser 300, the overlap amount is desirably 50% or less. Thus, by making the overlap amount larger than 0% but 50% or less, the wiring inductance is reduced, and excellent heat radiation characteristics can be obtained.

[Wiring inductance]

As described above, the wiring inductance becomes a problem in the connection between the semiconductor laser 300 and the laser driver 200. All conductors have an inductive component, and even an inductance of an extremely short lead wire may cause adverse effects in high frequency regions such as a ToF system. That is, when a high frequency operation is performed, the driving waveform for driving the semiconductor laser 300 from the laser driver 200 is distorted due to the influence of the wiring inductance, and the operation may become unstable.

Here, a theoretical equation for calculating the wiring inductance is examined. For example, the inductance IDC [$\mu$H] of a straight lead wire having a circular cross section with a length L [mm] and a radius R [mm] is represented in free space by the following equation. Note that ln represents the natural logarithm.

$$IDC = 0.0002L \cdot (\ln(2L/R) - 0.75)$$

In addition, for example, the inductance IDC [$\mu$H] of a strip line (substrate wiring pattern) having a length L [mm], a width W [mm], and a thickness H [mm] is represented in free space by the following equation.

$$IDC = 0.0002L \cdot (\ln(2L/(W + H)) + 0.2235((W + H)/L) + 0.5)$$

FIG. 4 and FIG. 5 illustrate the preliminary calculation of the wiring inductance [nH] between the laser driver incorporated inside the printed wiring board and the semiconductor laser electrically connected to an upper portion of the printed wiring board.

FIG. 4 is a diagram for illustrating a numerical example of a wiring inductance with respect to a wiring length L and a wiring width W in the case where a wiring pattern is formed by an additive method. The additive method is a method of forming a pattern by depositing copper only on a necessary part of an insulating resin surface.

FIG. 5 is a diagram for illustrating a numerical example of the wiring inductance with respect to the wiring length L and the wiring width W in the case where a wiring pattern is formed by a subtractive method. The subtractive is a method of forming a pattern by etching an unnecessary part of a copper-clad laminate.

In the case of a semiconductor laser driving apparatus such as a ToF system, when assuming to drive at several hundred megahertz, the wiring inductance is desirably 0.5 nH or less, and more preferably 0.3 nH or less. Thus, when considering the above-described preliminary calculation result, it is considered that the wiring length between the semiconductor laser 300 and the laser driver 200 is desirably 0.5 millimeters or less, and more preferably 0.3 millimeters or less.

[Manufacturing method]

FIG. 6 and FIG. 7 are diagrams each illustrating an example of a process of processing a copper land and copper redistribution layer (RDL) in a manufacturing process of the laser driver 200 of the embodiment of the present technique.

First, as illustrated in a of FIG. 6, an I/O pad 210 made of, for example, aluminum or the like is formed on a semiconductor wafer. Then, a protective insulating layer 220 such as SiN is deposited on the surface, and a region of the I/O pad 210 is opened.

Next, as illustrated in b of FIG. 6, a surface protective film 230 made of polyimide (PI) or polybenzoxazole (PBO) is deposited, and a region of the I/O pad 210 is opened.

Then, as illustrated in c of FIG. 6, titanium tungsten (TiW) of approximately several tens to hundreds nm and copper (Cu) of approximately 100 to 1000 nm are sequentially sputtered to form an adhesion layer and seed layer 240. Here, in addition to titanium tungsten (TiW), a refractory metal such as chromium (Cr), nickel (Ni), titanium (Ti), titanium copper (TiCu), or platinum (Pt), or an alloy thereof may be applied to the adhesion layer. Further, in addition to copper (Cu), nickel (Ni), silver (Ag), gold (Au), or an alloy thereof may be applied to the seed layer.

Subsequently, as illustrated in d of FIG. 7, a photoresist 250 is patterned in order to form a copper land and copper redistribution layer for electrical bonding. Specifically, the copper land and copper redistribution layer for electrical bonding is formed by each of processes of surface cleaning, resist coating, drying, exposure, and development.

Then, as illustrated in e of FIG. 7, a copper land and copper redistribution layer (RDL) 260 for electrical bonding is formed on the adhesion layer and seed layer 240 by a plating method. Here, as the plating method, for example, an electrolytic copper plating method, an electrolytic nickel plating method, or the like can be used. In addition, it is desirable that the diameter of the copper land be approximately 50 to 100 micrometers, the thickness of the copper redistribution layer be approximately 3 to 10 micrometers, and the minimum width of the copper redistribution layer be approximately 10 micrometers.

Next, as illustrated in f of FIG. 7, the photoresist 250 is removed, and the copper land and copper redistribution layer (RDL) 260 of the semiconductor chip is masked and dry-etched. Here, as the dry etching, for example, ion milling for applying an argon ion beam can be used. An unnecessary region of the adhesion layer and seed layer 240 can be selectively removed by the dry etching, and the copper land and copper redistribution layers are separated from each other. It should be noted that the unnecessary region can be removed by wet etching using an aqueous solution of aqua regia, cerium (TV) nitrate ammonium, or potassium hydroxide, but is desirably removed by dry etching in consideration of side etching and thickness reduction of metal layers configuring the copper land and copper redistribution layer.

FIG. 8 to FIG. 12 are diagrams each illustrating an example of a manufacturing process of the substrate 100 according to the embodiment of the present technique.

First, as illustrated in a of FIG. 8, a peelable copper foil 130 having a two-layer structure of an ultra-thin copper foil 132 and a carrier copper foil 131 is thermocompression bonded to one surface of a support plate 110 via an adhesive resin layer 120 by roll laminating or laminating press.

As the support plate 110, a substrate made of an inorganic material, a metal material, a resin material, or the like can be used. For example, silicon (Si), glass, ceramic, copper, a copper-based alloy, aluminum, an aluminum alloy, stainless steel, a polyimide resin, or an epoxy resin can be used.

The carrier copper foil 131 having a thickness of 18 to 35 micrometers is vacuum-adhered to the ultra-thin copper foil 132 having a thickness of 2 to 5 micrometers, to be used as the peelable copper foil 130. As the peelable copper foil 130, for example, 3FD-P3/35 (made by Furukawa Circuit Foil Co., Ltd.), MT-18S5DH (made by MITSUI MINING & SMELTING CO., LTD.), or the like can be used.

As a resin material of the adhesive resin layer 120, an organic resin containing a reinforcing material of a glass fiber, such as an epoxy resin, a polyimide resin, a PPE resin, a phenol resin, a PTFE resin, a silicon resin, a polybutadiene resin, a polyester resin, a melamine resin, a urea resin, a PPS resin, and a PPO resin can be used. In addition, as the reinforcing material, an aramid nonwoven fabric, an aramid fiber, a polyester fiber, or the like can be used in addition to the glass fiber.

Next, as illustrated in b of FIG. 8, a plating base conductive layer (not illustrated) having a thickness of 0.5 to 3 micrometers is formed on the surface of the ultra-thin copper foil 132 of the peelable copper foil 130 by an electroless copper plating treatment. It should be noted that, in the electroless copper plating treatment, a conductive layer is formed as a base of electrolytic copper plating for forming a wiring pattern next. However, by omitting the electroless copper plating treatment, an electrode for electrolytic copper plating may be brought into direct contact with the peelable copper foil 130, and an electrolytic copper plating treatment may be directly applied on the peelable copper foil 130 to form a wiring pattern.

Then, as illustrated in c of FIG. 8, a photosensitive resist is pasted on the surface of the support plate by roll laminating, to form a resist pattern (solder resist 140) for a wiring pattern. As the photosensitive resist, for example, a plating resist of a dry film can be used.

Subsequently, as illustrated in d of FIG. 8, a wiring pattern 150 having a thickness of approximately 15 micrometers is formed by an electrolytic copper plating treatment.

Then, as illustrated in e of FIG. 9, the plating resist is peeled off. Then, as a pretreatment for forming an interlayer insulating resin, the surface of the wiring pattern is roughened to improve the adhesion between the interlayer insulating resin and the wiring pattern. It should be noted that the roughening treatment can be performed by a blackening treatment by an oxidation/reduction treatment or a soft etching treatment using a sulfuric acid hydrogen peroxide mixture.

Next, as illustrated in f of FIG. 9, an interlayer insulating resin 161 is thermocompression bonded on the wiring pattern by roll laminating or laminating press. For example, an epoxy resin having a thickness of 45 micrometers is roll-laminated. In the case where a glass epoxy resin is used, copper foils having any thickness are superposed and thermocompression bonded by laminating press. As a resin material of the interlayer insulating resin 161, an organic resin such as an epoxy resin, a polyimide resin, a PPE resin, a phenol resin, a PTFE resin, a silicon resin, a polybutadiene resin, a polyester resin, a melamine resin, a urea resin, a PPS resin, and a PPO resin can be used. In addition, these resins alone or a combination of resins obtained by mixing a plurality of resins or preparing a compound can be used. Further, an interlayer insulating resin obtained by containing an inorganic filler in these materials or mixing a reinforcing material of a glass fiber can also be used.

Then, as illustrated in g of FIG. 9, a via hole for interlayer electrical connection is formed by a laser method or a photoetching method. In the case where the interlayer insulating resin 161 is a thermosetting resin, the via hole is formed by a laser method. As a laser beam, an ultraviolet laser such as a harmonic YAG laser or an excimer laser or an infrared laser such as a carbon dioxide gas laser can be used. It should be noted that, in the case where the via hole is formed by a laser beam, a desmear treatment is performed because a thin resin film may remain at the bottom of the via hole. In the desmear treatment, the resin is swollen by a strong alkali, and the resin is decomposed and removed by using an oxidizing agent such as chromic acid or a permanganate aqueous solution. In addition, the resin can also be removed by a plasma treatment or a sandblasting treatment by an abrasive material. In the case where the interlayer insulating resin 161 is a photosensitive resin, the via hole 170 is formed by a photoetching method. That is, the via hole 170 is formed by development after exposure using ultraviolet rays through a mask.

Next, after the roughening treatment, an electroless plating treatment is performed on the wall surface of the via hole 170 and the surface of the interlayer insulating resin 161. Then, a photosensitive resist is pasted by roll laminating on the surface of the interlayer insulating resin 161 subjected to the electroless plating treatment. As the photosensitive resist in this case, for example, a photosensitive plating resist film of a dry film can be used. The photosensitive plating resist film is exposed and then developed, so that a plating resist pattern with the portion of the via hole 170 and the portion of the wiring pattern being opened is formed. Subsequently, the opening portions of the plating resist pattern are subjected to a treatment of applying an electrolytic copper plating having a thickness of 15 micrometers. Then, the plating resist is peeled off, and the electroless plating remaining on the interlayer insulating resin is removed by flash etching using a sulfuric acid hydrogen peroxide mixture or the like, so that the via hole 170 filled with copper plating and the wiring pattern as illustrated in h of FIG. 9 are formed. Then, the similar steps of roughening the wiring pattern and forming the interlayer insulating resin 162 are repeated.

Subsequently, as illustrated in i of FIG. 10, the laser driver 200 with a die attach film (DAF) 290 obtained by processing the copper land and copper redistribution layer with a thickness reduced to approximately 30 to 50 micrometers is mounted in a face-up state.

Then, as illustrated in j of FIG. 10, the interlayer insulating resin 163 is thermocompression bonded by roll laminating or laminating press.

Next, as illustrated in k of FIG. 10 and l of FIG. 11, the via hole processing, the desmear treatment, the roughening treatment, the electroless plating treatment, and the electrolytic plating treatment similar to the above are performed. It should be noted that processing of a shallow via hole 171 for the copper land of the laser driver 200 and processing of a deep via hole 172 located one layer below, the desmear treatment, and the roughening treatment are performed simultaneously.

Here, the shallow via hole 171 is a filled via filled with copper plating. Each of the size and depth of the via is approximately 20 to 30 micrometers. In addition, the size of the diameter of the land is approximately 60 to 80 micrometers.

On the other hand, the deep via hole 172 is what is generally called a conformal via in which copper plating is applied only to the outside of the via. Each of the size and depth of the via is approximately 80 to 150 micrometers. In addition, the size of the diameter of the land is approximately 150 to 200 micrometers. It should be noted that it is desirable that the deep via hole 172 be arranged via an insulating resin of approximately 100 micrometers from the outer shape of the laser driver 200.

Next, as illustrated in m of FIG. 11, the interlayer insulating resin similar to the above is thermocompression bonded by roll laminating or laminating press. At this time, the inside of the conformal via is filled with the interlayer insulating resin. Then, the via hole processing, the desmear treatment, the roughening treatment, the electroless plating treatment, and the electrolytic plating treatment similar to the above are performed.

Subsequently, as illustrated in n of FIG. 11, the support plate 110 is separated by being peeled off from the interface between the carrier copper foil 131 and the ultra-thin copper foil 132 of the peelable copper foil 130.

Then, as illustrated in o of FIG. 12, by removing the ultra-thin copper foil 132 and the plating base conductive layer with use of sulfuric acid-hydrogen peroxide-based soft etching, it is possible to obtain a component-incorporated substrate with the wiring pattern exposed.

Next, as illustrated in p of FIG. 12, a solder resist 180 of a pattern having an opening at the land portion of the wiring pattern is printed on the exposed wiring pattern. It should be noted that the solder resist 180 can be formed by a roll coater with use of a film type. Then, an electroless Ni plating of 3 micrometers or more is formed at the land portion of the opening of the solder resist 180, and an electroless Au plating of 0.03 micrometers or more is formed thereon. The electroless Au plating may be formed by one micrometer or more. Further, solder can be precoated thereon. Alternatively, an electrolytic Ni plating of 3 micrometers or more may be formed at the opening of the solder resist 180, and an electrolytic Au plating of 0.5 micrometers or more may be formed thereon. Further, other than the metal plating, an organic rust preventive film may be formed at the opening of the solder resist 180.

In addition, a BGA (Ball Grid Array) of solder balls may be mounted on the land for external connection by printing and applying cream solder as a connection terminal. In addition, as the connection terminal, a copper core ball, a copper pillar bump, a land grid array (LGA), or the like may be used.

The semiconductor laser 300, the photodiode 400, and the passive component 500 are mounted on the surface of the substrate 100 thus manufactured as described above, and the MUF 610 and the diffusion plate 700 are attached thereto. In general, after performing the processing in the form of an aggregate substrate, the outer shape is processed by a dicer or the like to be separated into individual pieces.

It should be noted that, although the example of using the peelable copper foil 130 and the support plate 110 has been described in the above process, a copper clad laminate (CCL) can be used instead. In addition, as the manufacturing method of incorporating the component into the substrate, a method of forming a cavity in the substrate and mounting the same may be used.

FIG. 13 depicts diagrams each illustrating an example of a manufacturing process of the semiconductor laser driving apparatus 10 according to the first embodiment of the present technique.

As illustrated in a and b of FIG. 13, the semiconductor laser 300 is mounted on the substrate 100 by mass reflow or thermal compression bonding.

Next, as illustrated in c of FIG. 13, the periphery of the connection terminal portion of the semiconductor laser 300 and portions corresponding to side walls of the semiconductor laser driving apparatus are integrally molded with the MUF 610. As the molding method in this case, either a transfer molding method or a compression molding method may be used. It should be noted that the light emitting surface of the semiconductor laser 300 needs to have a structure of not being covered with the MUF 610. Thus, the structure is molded so as not to be filled with the MUF 610, by using a mold.

Finally, as illustrated in d of FIG. 13, the diffusion plate 700 is attached.

By such a process, the outer wall of the semiconductor laser driving apparatus 10 can simultaneously be formed while the connection terminal portion of the semiconductor laser 300 is protected by use of the MUF 610.

As described above, according to the first embodiment of the present technique, the electrical connection between the semiconductor laser 300 and the laser driver 200 is made via the connection via 101, so that the wiring inductance can be reduced. Specifically, the wiring inductance can be reduced to 0.5 nanohenries or less by making the wiring length between them 0.5 millimeters or less. In addition, by making the amount of overlap between the semiconductor laser 300 and the laser driver 200 50% or less, a certain number of thermal vias can be arranged directly under the semiconductor laser 300, and excellent heat radiation characteristics can be obtained. In addition, by using the MUF 610, the outer wall of the semiconductor laser driving apparatus 10 can simultaneously be formed while the connection terminal portion of the semiconductor laser 300 is protected.

<2. Second Embodiment>

In the above-described first embodiment, the example of forming the solder bumps 301 at the connection terminal portion of the semiconductor laser 300 has been described, but the structure of the connection terminal portion is not limited thereto. In a second embodiment, an example of realizing the connection between the semiconductor laser 300 and the substrate 100 by using a bonding wire will be described. It should be noted that, since the substrate 100 itself incorporating the laser driver 200 is similar to that of the above-described first embodiment, the detailed description thereof will be omitted.

[Semiconductor laser driving apparatus]

FIG. 14 is a diagram for illustrating an example of a cross-sectional view of a semiconductor laser driving apparatus 10 according to the second embodiment of the present technique.

A bonding wire 302 is formed as the connection terminal portion of the semiconductor laser 300. Accordingly, the semiconductor laser 300 and the wiring of the substrate 100 are electrically connected to each other.

The semiconductor laser 300, the photodiode 400, and the passive component 500 mounted on the surface of the substrate 100 are surrounded by a resin mold 620. In the second embodiment, unlike the above-described first embodiment, no underfill is formed between the semiconductor laser 300 and the substrate 100. It should be noted that the resin mold 620 is an example of the sealing portion described in the claims.

The upper surface surrounded by the resin mold 620 is covered with the diffusion plate 700.

[Manufacturing method]

FIG. 15 depicts diagrams each illustrating an example of a manufacturing process of the semiconductor laser driving apparatus 10 according to the second embodiment of the present technique.

As illustrated in a and b of FIG. 15, the semiconductor laser 300 is die-attached to the substrate 100 by conductive paste, and the bonding wire 302 is formed. Accordingly, the semiconductor laser 300 and the wiring of the substrate 100 are electrically connected to each other.

Next, as illustrated in c of FIG. 15, the periphery of the semiconductor laser 300 and portions corresponding to side walls of the semiconductor laser driving apparatus 10 are integrally molded with a thermosetting resin. As the molding method in this case, either a transfer molding method or a compression molding method may be used.

Finally, as illustrated in d of FIG. 15, the diffusion plate 700 is attached.

By such a process, the outer wall of the semiconductor laser driving apparatus 10 can simultaneously be formed while the bonding wire 302 is protected by use of the resin mold 620.

As described above, according to the second embodiment of the present technique, the outer wall of the semiconductor laser driving apparatus 10 can simultaneously be formed while the bonding wire 302 is protected by use of the resin mold 620 in the semiconductor laser driving apparatus 10 in which the wiring inductance is reduced.

<3. Third Embodiment>

In the above-described first embodiment, the formation of the outer wall of the semiconductor laser driving apparatus 10 and the protection of the connection terminal portion of the semiconductor laser 300 are simultaneously performed by use of the MUF 610, but the two structures can be formed individually. In the third embodiment, an example of a case in which a capillary underfill is used will be described. It should be noted that, since the substrate 100 itself incorporating the laser driver 200 is similar to that of the above-described first embodiment, the detailed description thereof will be omitted.

[Semiconductor laser driving apparatus]

FIG. 16 is a diagram for illustrating an example of a cross-sectional view of a semiconductor laser driving apparatus 10 according to the third embodiment of the present technique.

The solder bumps 301 are formed at the connection terminal portion of the semiconductor laser 300 as in the above-described first embodiment. In addition, similarly, other materials such as a copper (Cu) pillar bump and a gold (Au) bump may be used as the connection terminal portion.

The connection terminal portion of the semiconductor laser 300 is surrounded by a CUF (Capillary UnderFill) 630. As a material of the CUF 630, for example, a thermosetting resin is assumed. It should be noted that the CUF 630 is an example of the sealing portion described in the claims.

Side walls 600 are formed around the semiconductor laser 300 mounted on the surface of the substrate 100. The upper surface surrounded by the side walls 600 is covered with the diffusion plate 700.

[Manufacturing method]

FIG. 17 depicts diagrams each illustrating an example of a manufacturing process of the semiconductor laser driving apparatus 10 according to a third embodiment of the present technique.

As illustrated in a and b of FIG. 17, the semiconductor laser 300 is mounted on the substrate 100 by mass reflow or thermal compression bonding.

Next, as illustrated in c of FIG. 17, the CUF 630 is applied. The underfill resin advances to a depth of a gap between the semiconductor laser 300 and the substrate 100 by utilizing the capillary phenomenon, and the bonding surface between the semiconductor laser 300 and the substrate 100 is resin-sealed. Thereafter, since the underfill resin of the CUF 630 is solidified by thermal curing, a step of curing the underfill resin is provided.

Then, as illustrated in d of FIG. 17, the periphery of the semiconductor laser 300 and portions corresponding to the side walls 600 of the semiconductor laser driving apparatus 10 are integrally molded with a thermosetting resin. As the molding method in this case, either a transfer molding method or a compression molding method may be used. In addition, side walls formed separately in advance may be pasted. Thereafter, the diffusion plate 700 is attached on the side walls 600.

By such a process, the outer wall of the semiconductor laser driving apparatus 10 can be formed by the side walls 600, apart from the structure for protecting the connection terminal portion of the semiconductor laser 300 by using the CUF 630.

As described above, according to the third embodiment of the present technique, the connection terminal portion of the semiconductor laser 300 can be protected by using the CUF 630 in the semiconductor laser driving apparatus 10 in which the wiring inductance is reduced.

<4. Application Example>

[Electronic equipment]

FIG. 18 is a diagram for illustrating a system configuration example of electronic equipment 800 as an application example of the embodiments of the present technique.

The electronic equipment 800 is a portable terminal in which the semiconductor laser driving apparatus 10 according to the above-described embodiments is mounted. The electronic equipment 800 includes an imaging unit 810, a semiconductor laser driving apparatus 820, a shutter button 830, a power button 840, a control unit 850, a storage unit 860, a wireless communication unit 870, a display unit 880, and a battery 890.

The imaging unit 810 is an image sensor for imaging a subject. The semiconductor laser driving apparatus 820 is the semiconductor laser driving apparatus 10 according to the above-described embodiments.

The shutter button 830 is a button for giving an instruction on an imaging timing in the imaging unit 810 from the outside of the electronic equipment 800. The power button 840 is a button for giving an instruction on on/off of the power of the electronic equipment 800 from the outside of the electronic equipment 800.

The control unit 850 is a processing unit that controls the entire electronic equipment 800. The storage unit 860 is a memory for storing data and programs necessary for the operation of the electronic equipment 800. The wireless communication unit 870 performs wireless communication with the outside of the electronic equipment 800. The display unit 880 is a display for displaying an image or the like. The battery 890 is a power supply source for supplying power to each unit of the electronic equipment 800.

The imaging unit 810 detects the light receiving amount from 0 to 180 degrees as Q1 and detects the light receiving amount from 180 to 360 degrees as Q2 with a specific phase (for example, rising timing) of a light emission control signal for controlling the semiconductor laser driving apparatus 820 defined as 0 degree. In addition, the imaging unit 810 detects the light receiving amount from 90 to 270 degrees as Q3 and detects the light receiving amount from 270 to 90 degrees as Q4. The control unit 850 computes a distance d to an object by the following equation on the basis of these light receiving amounts Q1 to Q4, and displays the distance d on the display unit 880.

$$d = (c/4\pi f) \times \arctan\{(Q3 - Q4)/(Q1 - Q2)\}$$

The unit of the distance d in the above equation is, for example, meters (m). In the equation, c is the speed of light, and the unit thereof is, for example, meters per second (m/s). In the equation, arctan is the inverse function of a tangent function. The value of "(Q3 - Q4)/(Q1 - Q2)" indicates a phase difference between the irradiated light and the reflected light. In the equation, $\pi$ indicates the ratio of the circumference of a circle to its diameter. In addition, f is the frequency of the irradiated light, and the unit thereof is, for example, megahertz (MHz).

FIG. 19 is a diagram for illustrating an external configuration example of the electronic equipment 800 as an application example of the embodiments of the present technique.

The electronic equipment 800 is housed in a housing 801, includes the power button 840 on a side surface, and includes the display unit 880 and the shutter button 830 on the front surface. In addition, optical regions of the imaging unit 810 and the semiconductor laser driving apparatus 820 are provided on the rear surface.

Accordingly, the display unit 880 can display not only a normal captured image 881 but also a depth image 882 according to the distance measurement result using ToF.

It should be noted that, in the application example, a portable terminal such as a smartphone is exemplified as the electronic equipment 800, but the electronic equipment 800 is not limited thereto, and may be, for example, a digital camera, a game machine, wearable equipment, or the like.

It should be noted that the above-described embodiments illustrate an example for embodying the present technique, and the matters in the embodiments have corresponding relations with the matters specifying the invention in the claims. Similarly, the matters specifying the invention in the claims have corresponding relations with the matters in the embodiments of the present technique to which the same names are given. However, the present technique is not limited to the embodiments, and can be embodied by applying various modifications to the embodiments without departing from the gist thereof.

It should be noted that the effects described in the specification are merely illustrative and not limitative, and other effects may be provided.

It should be noted that the present technique can also be configured as follows.

(1) A semiconductor laser driving apparatus including:

a substrate incorporating a laser driver;
a semiconductor laser mounted on one surface of the substrate;
connection wiring that electrically connects the laser driver and the semiconductor laser to each other with a wiring inductance of 0.5 nanohenries or less; and
a sealing portion that seals a connection terminal portion of the semiconductor laser for the substrate.

(2) The semiconductor laser driving apparatus according to (1), in which the sealing portion forms an outer wall surrounding a region including the semiconductor laser.

(3) The semiconductor laser driving apparatus according to (2), in which a bump is formed at the connection terminal portion of the semiconductor laser, and
the sealing portion is a mold underfill covering a region including the bump.

(4) The semiconductor laser driving apparatus according to (2),

in which a bonding wire is formed at the connection terminal portion of the semiconductor laser, and
the sealing portion is a resin mold covering a region including the bonding wire.

(5) The semiconductor laser driving apparatus according to (2), further including:
a diffusion plate covering an upper part of a region surrounded by the outer wall.

(6) The semiconductor laser driving apparatus according to any one of (1) to (5),
in which a light emitting surface of the semiconductor laser has a structure of not being covered with the sealing portion.

(7) The semiconductor laser driving apparatus according to (1), in which the sealing portion is a capillary underfill.

(8) The semiconductor laser driving apparatus according to any one of (1) to (7),
in which the connection wiring has a length of 0.5 millimeters or less.

(9) The semiconductor laser driving apparatus according to any one of (1) to (8),

in which the connection wiring is provided via a connection via provided in the substrate.

(10) The semiconductor laser driving apparatus according to any one of (1) to (9),

in which the semiconductor laser is arranged in such a manner that a part thereof overlaps an upper part of the laser driver.

(11) The semiconductor laser driving apparatus according to (10),

in which the semiconductor laser is arranged in such a manner that a part corresponding to 50% or less of an area thereof overlaps the upper part of the laser driver.

(12) Electronic equipment including:

a substrate incorporating a laser driver;

a semiconductor laser mounted on one surface of the substrate;

connection wiring that electrically connects the laser driver and the semiconductor laser to each other with a wiring inductance of 0.5 nanohenries or less; and

a sealing portion that seals a connection terminal portion of the semiconductor laser for the substrate.

(13) A manufacturing method of a semiconductor laser driving apparatus, including:

a step of forming a laser driver on an upper surface of a support plate;

a step of forming a substrate incorporating the laser driver by forming connection wiring of the laser driver;

a step of mounting a semiconductor laser on one surface of the substrate and forming connection wiring that electrically connects the laser driver and the semiconductor laser to each other via the connection wiring with a wiring inductance of 0.5 nanohenries or less; and

a step of forming a sealing portion that seals a connection terminal portion of the semiconductor laser for the substrate.

[Reference Signs List]

| 10: | Semiconductor laser driving apparatus |
| 100: | Substrate |
| 101: | Connection via |
| 110: | Support plate |
| 120: | Adhesive resin layer |
| 130: | Peelable copper foil |
| 131: | Carrier copper foil |
| 132: | Ultra-thin copper foil |
| 140: | Solder resist |
| 150: | Wiring pattern |
| 161 to 163: | Interlayer insulating resin |
| 170 to 172: | Via hole |
| 180: | Solder resist |
| 200: | Laser driver |
| 210: | I/O pad |
| 220: | Protective insulating layer |
| 230: | Surface protective film |
| 240: | Adhesion layer and seed layer |
| 250: | Photoresist |
| 260: | Copper land and copper redistribution layer (RDL) |
| 290: | Die attach film (DAF) |
| 300: | Semiconductor laser |
| 301: | Solder bump |
| 302: | Bonding wire |
| 400: | Photodiode |
| 500: | Passive component |
| 600: | Side wall |
| 610: | MUF (Mold UnderFill) |
| 620: | Resin mold |

630:        CUF (Capillary UnderFill)
700:        Diffusion plate
800:        Electronic equipment
801:        Housing
810:        Imaging unit
820:        Semiconductor laser driving apparatus
830:        Shutter button
840:        Power button
850:        Control unit
860:        Storage unit
870:        Wireless communication unit
880:        Display unit
890:        Battery

**Claims**

1. A semiconductor laser driving apparatus comprising:

   a substrate incorporating a laser driver;
   a semiconductor laser mounted on one surface of the substrate;
   connection wiring that electrically connects the laser driver and the semiconductor laser to each other with a wiring inductance of 0.5 nanohenries or less; and
   a sealing portion that seals a connection terminal portion of the semiconductor laser for the substrate.

2. The semiconductor laser driving apparatus according to claim 1, wherein the sealing portion forms an outer wall surrounding a region including the semiconductor laser.

3. The semiconductor laser driving apparatus according to claim 2,

   wherein a bump is formed at the connection terminal portion of the semiconductor laser, and
   the sealing portion is a mold underfill covering a region including the bump.

4. The semiconductor laser driving apparatus according to claim 2,

   wherein a bonding wire is formed at the connection terminal portion of the semiconductor laser, and
   the sealing portion is a resin mold covering a region including the bonding wire.

5. The semiconductor laser driving apparatus according to claim 2, further comprising:
   a diffusion plate covering an upper part of a region surrounded by the outer wall.

6. The semiconductor laser driving apparatus according to claim 1, wherein a light emitting surface of the semiconductor laser has a structure of not being covered with the sealing portion.

7. The semiconductor laser driving apparatus according to claim 1, wherein the sealing portion is a capillary underfill.

8. The semiconductor laser driving apparatus according to claim 1,
   wherein the connection wiring has a length of 0.5 millimeters or less.

9. The semiconductor laser driving apparatus according to claim 1, wherein the connection wiring is provided via a connection via provided in the substrate.

10. The semiconductor laser driving apparatus according to claim 1, wherein the semiconductor laser includes a vertical cavity surface emitting laser (VCSEL).

11. The semiconductor laser driving apparatus according to claim 1, wherein the semiconductor laser is arranged in such a manner that a part thereof overlaps an upper part of the laser driver.

**12.** The semiconductor laser driving apparatus according to claim 11, wherein the semiconductor laser is arranged in such a manner that a part corresponding to 50% or less of an area thereof overlaps the upper part of the laser driver.

**13.** Electronic equipment comprising:

a substrate incorporating a laser driver;
a semiconductor laser mounted on one surface of the substrate;
connection wiring that electrically connects the laser driver and the semiconductor laser to each other with a wiring inductance of 0.5 nanohenries or less; and
a sealing portion that seals a connection terminal portion of the semiconductor laser for the substrate.

**14.** A manufacturing method of a semiconductor laser driving apparatus, comprising:

a step of forming a laser driver on an upper surface of a support plate;
a step of forming a substrate incorporating the laser driver by forming connection wiring of the laser driver;
a step of mounting a semiconductor laser on one surface of the substrate and forming connection wiring that electrically connects the laser driver and the semiconductor laser to each other via the connection wiring with a wiring inductance of 0.5 nanohenries or less; and
a step of forming a sealing portion that seals a connection terminal portion of the semiconductor laser for the substrate.

**15.** A semiconductor laser driving apparatus comprising:

a substrate incorporating a laser driver;
a semiconductor laser mounted on one surface of the substrate so as to overlap the laser driver;
a solder bump arranged between the substrate and the semiconductor laser; and
a sealing portion that covers the solder bump and contains resin.

**16.** The semiconductor laser driving apparatus according to claim 15, wherein the semiconductor laser includes a vertical cavity surface emitting laser (VCSEL).

**17.** The semiconductor laser driving apparatus according to claim 15, further comprising:
side walls surrounding a region including the semiconductor laser on the one surface of the substrate.

**18.** The semiconductor laser driving apparatus according to claim 17, further comprising:
a diffusion plate covering an upper part of a region surrounded by the side walls.

**19.** The semiconductor laser driving apparatus according to claim 15,

wherein the sealing portion forms an outer wall surrounding a region including the semiconductor laser, and
a diffusion plate covering an upper surface surrounded by the outer wall is further provided.

# F I G . 1

SEMICONDUCTOR LASER
DRIVING APPARATUS 10

SUBSTRATE   LASER
100    DRIVER 200

SEMICONDUCTOR
LASER 300

A

B

400
PHOTODIODE

500
PASSIVE COMPONENT

# F I G . 2

DIFFUSION PLATE
700

MUF
610

200
LASER DRIVER

100
SUBSTRATE

101
CONNECTION VIA

301
SOLDER
BUMP

300
SEMICONDUCTOR
LASER

# FIG.3

a    OVERLAP: 0%

b    OVERLAP: 50%

c    OVERLAP: 100%

# F I G . 4

ADDITIVE METHOD (H=15μm)

| | | L | | | | |
|---|---|---|---|---|---|---|
| | | 0. 3mm | 0. 5mm | 1mm | 2mm | 3mm |
| W | 0. 015mm | 0. 21 | 0. 40 | 0. 94 | 2. 16 | 3. 48 |
| | 0. 05mm | 0. 16 | 0. 33 | 0. 79 | 1. 85 | 3. 02 |
| | 0. 1mm | 0. 13 | 0. 27 | 0. 68 | 1. 63 | 2. 69 |
| | 0. 2mm | 0. 09 | 0. 21 | 0. 56 | 1. 39 | 2. 33 |
| | 0. 3mm | 0. 07 | 0. 17 | 0. 48 | 1. 24 | 2. 11 |

# F I G . 5

SUBTRACTIVE METHOD (H=35μm)

| | | L | | | | |
|---|---|---|---|---|---|---|
| | | 0. 3mm | 0. 5mm | 1mm | 2mm | 3mm |
| W | 0. 035mm | 0. 16 | 0. 32 | 0. 77 | 1. 82 | 2. 98 |
| | 0. 05mm | 0. 15 | 0. 30 | 0. 73 | 1. 75 | 2. 86 |
| | 0. 1mm | 0. 12 | 0. 25 | 0. 65 | 1. 57 | 2. 59 |
| | 0. 2mm | 0. 09 | 0. 20 | 0. 54 | 1. 35 | 2. 27 |
| | 0. 3mm | 0. 07 | 0. 17 | 0. 47 | 1. 22 | 2. 07 |

# FIG.6

PROTECTIVE
INSULATING LAYER 220

I/O PAD
210

<u>a</u>

PI/PBO
230

<u>b</u>

ADHESION LAYER/SEED LAYER
240

<u>c</u>

# FIG.7

PHOTORESIST
250

<u>d</u>

COPPER LAND/COPPER
REDISTRIBUTION
LAYER (RDL) 260

<u>e</u>

<u>f</u>

# FIG.8

ADHESIVE
RESIN LAYER
120

PEELABLE COPPER FOIL 130

CARRIER       ULTRA-THIN
COPPER FOIL  COPPER FOIL
131             132

SUPPORT PLATE 110

a

b

SOLDER RESIST 140

c

WIRING PATTERN
150

d

# FIG.9

e

INTERLAYER
INSULATING RESIN
161

f

VIA HOLE 170

g

INTERLAYER
INSULATING RESIN
162

h

# FIG.10

LASER DRIVER
200

260
210
DIE ATTACH FILM (DAF)
290

i

163

i

SHALLOW VIA HOLE
171
DEEP VIA HOLE
172

k

# F I G . 1 1

l

m

n

# FIG.12

o

SOLDER RESIST
180

180
SOLDER RESIST

p

# FIG.13

a

b

c

d

# FIG.14

DIFFUSION PLATE
700

RESIN
MOLD
620

200          100                101                                        302
LASER DRIVER  SUBSTRATE  CONNECTION VIA   300        BONDING WIRE
                                        SEMICONDUCTOR
                                        LASER

# FIG.15

a

b

c

d

# FIG.16

DIFFUSION PLATE
700

SIDE
WALL
600

200
LASER DRIVER

100
SUBSTRATE

101
CONNECTION
VIA

630
CUF

301
SOLDER
BUMP

300
SEMICONDUCTOR
LASER

# FIG.17

a

b

c

d

# FIG.18

ELECTRONIC
EQUIPMENT
800

810

IMAGING UNIT

820

SEMICONDUCTOR
LASER DRIVING
APPARATUS

830

SHUTTER
BUTTON

840

POWER BUTTON

850

CONTROL UNIT

890

BATTERY

860

STORAGE UNIT

870

WIRELESS
COMMUNICATION
UNIT

880

DISPLAY UNIT

# FIG.19

ELECTRONIC EQUIPMENT
800

DISPLAY UNIT
880

POWER BUTTON
840

IMAGING UNIT
810

SEMICONDUCTOR LASER
DRIVING APPARATUS
820

HOUSING
801

830
SHUTTER BUTTON

881

882

1. 5m                    0. 3m

## INTERNATIONAL SEARCH REPORT

| International application No. |
|---|
| PCT/JP2020/022471 |

A.  CLASSIFICATION OF SUBJECT MATTER
Int.Cl.  H01S5/022(2006.01)i
FI: H01S5/022

According to International Patent Classification (IPC) or to both national classification and IPC

B.  FIELDS SEARCHED

Minimum documentation searched (classification system followed by classification symbols)
Int.Cl.  H01S5/00-5/50

Documentation searched other than minimum documentation to the extent that such documents are included in the fields searched
Published examined utility model applications of Japan        1922-1996
Published unexamined utility model applications of Japan      1971-2020
Registered utility model specifications of Japan              1996-2020
Published registered utility model applications of Japan      1994-2020

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y<br>A | WO 01/97294 A2 (PEREGRINE SEMICONDUCTOR CORPORATION) 20.12.2001 (2001-12-20), page 8, line 22 to page 9, line 3, page 29, line 20 to page 30, line 11, page 32, line 20 to page 34, line 12, fig. 2A, 3A | 1, 6-17<br>2-5, 18-19 |
| Y | JP 2013-97305 A (TOSHIBA CORPORATION) 20.05.2013 (2013-05-20), paragraph [0026], fig. 2 | 1, 6-17 |
| Y | US 2018/0367767 A1 (APPLE INC.) 20.12.2018 (2018-12-20), paragraph [0060], fig. 3B | 9 |
| Y | WO 2015/136099 A2 (MESA IMAGING AG) 17.09.2015 (2015-09-17), paragraphs [0033]-[0039], fig. 2 | 17 |
| A | US 2015/0229912 A1 (MICROSOFT CORPORATION) 13.08.2015 (2015-08-13), entire text, all drawings | 1-19 |

☐  Further documents are listed in the continuation of Box C.      ☒  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14.08.2020 | 25.08.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

INTERNATIONAL SEARCH REPORT
Information on patent family members

International application No.

PCT/JP2020/022471

| | | | |
|---|---|---|---|
| WO 01/97294 A2 | 20.12.2001 | US 6583445 B1<br>AU 6707901 A | |
| JP 2013-97305 A | 20.05.2013 | (Family: none) | |
| US 2018/0367767 A1 | 20.12.2018 | WO 2018/232261 A2<br>CN 110754078 A | |
| WO 2015/136099 A2 | 17.09.2015 | US 2017/0090018 A1<br>paragraphs [0033]-[0039], fig. 2<br>CN 106104296 A<br>KR 10-2016-0132962 A<br>SG 11201606511Y A<br>TW 201539011 A | |
| US 2015/0229912 A1 | 13.08.2015 | WO 2015/119979 A2<br>EP 3105615 A2<br>CN 105992960 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009170675 A